(19) Europäisches Patentamt
European Patent Office
Office européen des brevets

(11) **EP 4 668 487 A1**

(12) **EUROPEAN PATENT APPLICATION**
published in accordance with Art. 153(4) EPC

(43) Date of publication:
**24.12.2025 Bulletin 2025/52**

(21) Application number: **24756623.5**

(22) Date of filing: **26.01.2024**

(51) International Patent Classification (IPC):
**H01Q 21/06** (2006.01)    **G01R 29/10** (2006.01)

(52) Cooperative Patent Classification (CPC):
**G01R 29/10; H01Q 21/06**

(86) International application number:
**PCT/JP2024/002505**

(87) International publication number:
**WO 2024/171772 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.02.2023 JP 2023020631**

(71) Applicant: **Fujikura Ltd.**
**Tokyo 135-8512 (JP)**

(72) Inventors:
• **TOJO, Yujiro**
**Sakura-shi, Chiba 285-8550 (JP)**
• **SHOJI, Takahito**
**Sakura-shi, Chiba 285-8550 (JP)**
• **KOBAYASHI, Hiroki**
**Sakura-shi, Chiba 285-8550 (JP)**

(74) Representative: **Lavoix**
**Bayerstraße 83**
**80335 München (DE)**

(54) **PHASED ARRAY ANTENNA EVALUATION METHOD**

(57)    An evaluation method for a phased array antenna evaluates a phased array antenna including a plurality of antennas that perform transmission or reception of a first polarized wave and a second polarized wave whose oscillation directions are orthogonal to each other. A reference antenna disposed to face the phased array antenna and performing transmission or reception of radio waves that oscillate in a reference direction is used. Evaluation of the first polarized wave and the second polarized wave are simultaneously performed in a state in which a first direction in which the first polarized wave oscillates is not parallel to the reference direction when viewed from a facing direction in which the phased array antenna and the reference antenna face each other, and a second direction in which the second polarized wave oscillates is not parallel to the reference direction when viewed from the facing direction.

FIG. 1

## Description

Technical Field

The present invention relates to an evaluation method for a phased array antenna.

Priority is claimed on Japanese Patent Application No. 2023-020631 filed on February 14, 2023, the content of which is incorporated herein by reference.

Background Art

Conventionally, an evaluation device for evaluating (inspecting) a phased array antenna having a plurality of antennas is known (for example, see Patent Document 1). The evaluation device of Patent Document 1 includes a plurality of reference antennas disposed to face a phased array antenna to be evaluated. Each of the reference antennas has a single reference direction. The reference antenna is capable of performing transmission or reception of radio waves that oscillate in the reference direction.

Citation List

Patent Document

Patent Document 1: Japanese Unexamined Patent Application, First Publication No. 2010-124360

Summary of Invention

Problem to be Solved by the Invention

Incidentally, each of the plurality of antennas provided in the phased array antenna may perform transmission and reception of an H-polarized wave and a V-polarized wave whose oscillation directions are orthogonal to each other. In such a case, from the perspective of evaluation efficiency, it is desirable to perform evaluation of the H-polarized wave and the V-polarized wave simultaneously. Hereinafter, a direction in which the H-polarized wave oscillates is referred to as an H-polarization direction, and a direction in which the V-polarized wave oscillates is referred to as a V-polarization direction.

In order to simultaneously evaluate the H-polarized wave and the V-polarized wave in the evaluation device of Patent Document 1, it is conceivable that one of the plurality of reference antennas (hereinafter referred to as a first reference antenna) and another one of the plurality of reference antennas (hereinafter referred to as a second reference antenna) are disposed as follows. That is, it is conceivable to dispose the first reference antenna and the second reference antenna such that a reference direction of the first reference antenna coincides with the H-polarization direction and a reference direction of the second reference antenna coincides with the V-polarization direction. According to this disposition, it is possible to perform evaluation of the H-polarized wave using the first reference antenna, and at the same time, it is possible to perform evaluation of the V-polarized wave using the second reference antenna.

Here, in order to properly transmit and receive radio waves using the two reference antennas described above, the two reference antennas need to be disposed at different positions in a direction parallel to the phased array antenna. This creates problems such as not being able to make both the first reference antenna and the second reference antenna to face a center of the phased array antenna.

The present invention has been made in consideration of such circumstances, and an objective of the present invention is to provide an evaluation method for a phased array antenna capable of simultaneously evaluating two polarized waves orthogonal to each other using a single reference antenna.

Means to Solve the Problem

In order to solve the above-described problems, an evaluation method for a phased array antenna according to aspect 1 of the present invention is an evaluation method for a phased array antenna, which evaluates a phased array antenna including a plurality of antennas that perform transmission or reception of a first polarized wave and a second polarized wave whose oscillation directions are orthogonal to each other, including using a reference antenna disposed to face the phased array antenna and performing transmission or reception of radio waves that oscillate in a reference direction in a state, and performing evaluation of the first polarized wave and the second polarized wave simultaneously in a state in which a first direction in which the first polarized wave oscillates is not parallel to the reference direction when viewed from a facing direction in which the phased array antenna and the reference antenna face each other, and a second direction in which the second polarized wave oscillates is not parallel to the reference direction when viewed from the facing direction.

According to aspect 1 of the present invention, since the reference direction is not parallel to either the first direction or the second direction, it is possible to perform simultaneous evaluation of the first polarized wave and the second polarized wave by the reference antenna. Also, it is possible to implement this method with a single reference antenna.

Also, according to aspect 2 of the present invention, in the evaluation method for a phased array antenna of aspect 1, a relative angle between the first direction and the reference direction is 35° or more and 55° or less when viewed from the facing direction.

Also, according to aspect 3 of the present invention, in the evaluation method for a phased array antenna of aspect 1 or 2, a center of the phased array antenna and a center of the reference antenna coincide when viewed from the facing direction.

Also, according to aspect 4 of the present invention, in the evaluation method for a phased array antenna of any one of aspects 1 to 3, the first polarized wave having a first frequency and the second polarized wave having a second frequency different from the first frequency are simultaneously transmitted from the phased array antenna, and the first polarized wave and the second polarized wave are simultaneously received by the reference antenna.

Also, according to aspect 5 of the present invention, in the evaluation method for a phased array antenna of any one of aspects 1 to 3, a first radio wave having a first frequency is transmitted from the reference antenna, and the first radio wave is received by the phased array antenna.

Also, according to aspect 6 of the present invention, in the evaluation method for a phased array antenna of aspect 5, the first radio wave and the second radio wave which has a second frequency different from the first frequency are transmitted from the reference antenna, and the first radio wave and the second radio wave are simultaneously received by the phased array antenna.

Effects of the Invention

According to the above-described aspects of the present invention, it is possible to provide an evaluation method for a phased array antenna capable of simultaneously evaluating two polarized waves orthogonal to each other using a single reference antenna.

Brief Description of Drawings

[FIG. 1] A diagram showing a positional relationship between a phased array antenna and a reference antenna in an embodiment of the present invention.
[FIG. 2A] A diagram showing a first example of a specific method for simultaneously evaluating an H-polarized wave and a V-polarized wave using the phased array antenna and the reference antenna which are in the positional relationship shown in FIG. 1.
[FIG. 2B] A diagram showing a second example of a specific method for simultaneously evaluating the H-polarized wave and the V-polarized wave using the phased array antenna and the reference antenna which are in the positional relationship shown in FIG. 1.
[FIG. 2C] A diagram showing a third example of a specific method for simultaneously evaluating the H-polarized wave and the V-polarized wave using the phased array antenna and the reference antenna which are in the positional relationship shown in FIG. 1.
[FIG. 3] A diagram showing a modified example of the present invention.
[FIG. 4] Graphs showing measurement results obtained by a spectrum analyzer for each case of (a) $\alpha$ = 0° and (b) $\alpha$ = 45°.
[FIG. 5] A graph showing effective radiated power of the H-polarized wave and the V-polarized wave for each of a plurality of antennas included in the phased array antenna.
[FIG. 6] Graphs showing beam patterns of the phased array antenna for each of cases in which (a) a beam directivity angle $\theta$ is -60°, (b) the beam directivity angle $\theta$ is -30°, (c) the beam directivity angle $\theta$ is 0°, (d) the beam directivity angle $\theta$ is 30°, and (e) the beam directivity angle $\theta$ is 60°.
[FIG. 7] Graphs showing beam patterns of the tiled phased array antenna for each of cases in which (a) the beam directivity angle $\theta$ is -60°, (b) the beam directivity angle $\theta$ is -30°, (c) the beam directivity angle $\theta$ is 0°, (d) the beam directivity angle $\theta$ is 30°, and (e) the beam directivity angle $\theta$ is 60°.
[FIG. 8A] A graph showing intensity variation of the H-polarized wave when a value of $\alpha$ is varied in a range of $-90° \leq \alpha \leq 90°$.
[FIG. 8B] A graph in which a range of $-55° \leq \alpha \leq -35°$ is extracted from the graph of FIG. 8A.
[FIG. 8C] A graph in which a range of $35° \leq \alpha \leq 55°$ is extracted from the graph of FIG. 8A.

Description of Embodiments

Hereinafter, an evaluation method for a phased array antenna according to an embodiment of the present invention will be described with reference to the drawings.

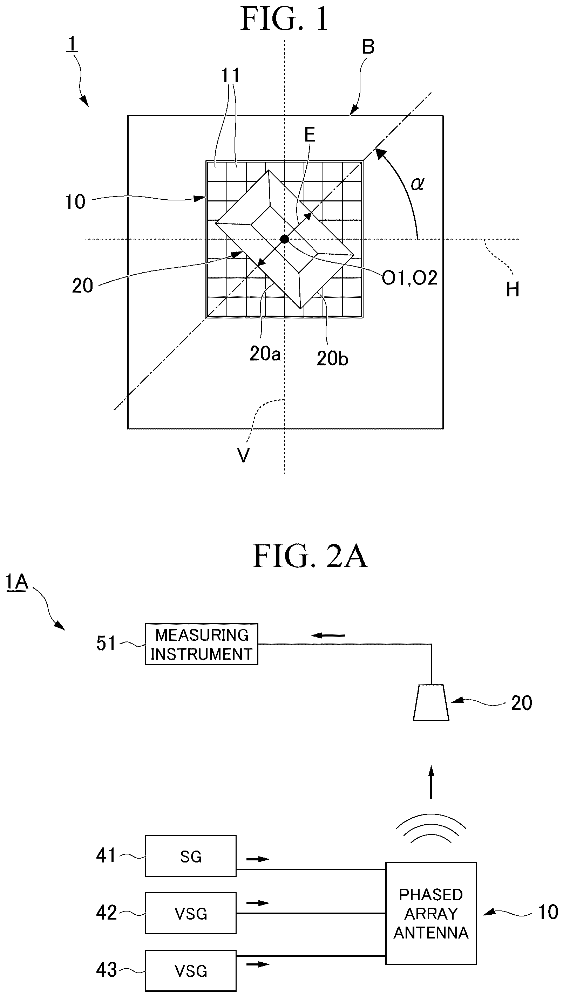

As shown in FIG. 1, an evaluation system (an evaluation system for a phased array antenna) 1 according to the present embodiment includes a phased array antenna 10 and a reference antenna 20. The phased array antenna 10 is mounted on a substrate B. The evaluation system 1 is a system that performs an evaluation of the phased array antenna 10 using the reference antenna 20.

The phased array antenna 10 has a plurality of antennas 11. Each antenna 11 performs transmission and reception of a first polarized wave and a second polarized wave whose directions of oscillation are orthogonal to each other. Hereinafter, a direction in which the first polarized wave oscillates is referred to as a first direction, and a direction in which the second polarized wave oscillates is referred to as a second direction. One of the first polarized wave and the second polarized wave is an H-polarized wave, and the other of the first polarized wave and the second polarized wave is a V-polarized wave. Hereinafter, description assumes that the first polarized wave is H-polarized wave and the second polarized wave is V-polarized wave. The first direction is referred to as an H-polarization direction (H pol. (H-polarization)) and is denoted by symbol H in the drawings. The second direction is referred to as a V-polarization direction (V pol. (V-polarization)) and is denoted by symbol V in the drawings.

The plurality of antennas 11 are arranged two-dimensionally in the V-polarization direction and the H-polarization direction. In the illustrated example, eight antennas 11 are arranged in both the V-polarization direction and the H-polarization direction. Thereby, a total of sixty-four antennas 11 are arranged two-dimensionally.

The reference antenna 20 performs transmission and reception of radio waves with the phased array antenna 10. The reference antenna 20 has a reference direction (electric field direction) E. The reference direction E is a single direction determined by a design of the reference antenna 20. The reference antenna 20 is capable of transmitting or receiving radio waves that oscillate in the reference direction E.

As the reference antenna 20, for example, a horn antenna may be used. In the illustrated example, a rectangular horn antenna having a pair of long sides 20a and a pair of short sides 20b in a plan view is employed as the reference antenna 20. In the reference antenna 20, the reference direction E is, for example, a direction parallel to the short side 20b. However, the reference direction E may be inclined with respect to the short side 20b.

The reference antenna 20 is disposed to face the phased array antenna 10 in a facing direction orthogonal to both the V-polarization direction and the H-polarization direction. In other words, the reference antenna 20 is disposed to overlap the phased array antenna 10 in a plan view from the facing direction. Particularly, it is desirable to dispose the phased array antenna 10 and the reference antenna 20 so that a center O1 of the phased array antenna 10 and a center O2 of the reference antenna 20 overlap in a plan view. Note that, the "facing direction" is also a direction orthogonal to an in-plane direction of the substrate B on which the phased array antenna 10 is mounted (in-plane direction of the phased array antenna 10).

In the present embodiment, as shown in FIG. 1, the reference antenna 20 is disposed to be inclined with respect to the phased array antenna 10. That is, the phased array antenna 10 and the reference antenna 20 are disposed so that, in a plan view, the H-polarization direction and the reference direction E are not parallel (a relative angle $\alpha$ is not 0°), and the V-polarization direction and the reference direction E are not parallel. More specifically, the phased array antenna 10 and the reference antenna 20 are disposed so that the relative angle $\alpha$ between the H-polarization direction and the reference direction E is approximately 45° in a plan view. Note that, a specific range of the relative angle $\alpha$ will be described later. Also, the phrase "the relative angle $\alpha$ is 45°" includes both a first case and a second case described below. The first case refers to a case in which an angle measured with a counterclockwise direction from the H-polarization direction as being positive in a plan view is 45° (the direction shown in FIG. 1). The second case refers to a case in which an angle measured with a clockwise direction from the H-polarization direction as being positive in a plan view is 45° (a direction opposite to the direction shown in FIG. 1). In the illustrated example, the relative angle between the H-polarization direction and the short side 20b of the reference antenna 20 is approximately 45°.

When the relative angle $\alpha$ between the phased array antenna 10 and the reference antenna 20 is set to approximately 45°, an angle formed by the H-polarization direction and the reference direction E and an angle formed by the V-polarization direction and the reference direction E become substantially the same. Thereby, when the H-polarized wave is transmitted and when the V-polarized wave is transmitted from the phased array antenna 10 to the reference antenna 20, intensities of the radio waves received by the reference antenna 20 become substantially the same. Also, when radio waves oscillating in the reference direction E are transmitted from the reference antenna 20 to the phased array antenna 10, the radio waves are received by the phased array antenna 10 with substantially the same intensity by a sensitivity in a direction parallel to the H-polarized wave and a sensitivity in a direction parallel to the V-polarized wave. In this way, when the relative angle $\alpha$ between the phased array antenna 10 and the reference antenna 20 is set to approximately 45°, it is possible to transmit and receive the H-polarized wave and the V-polarized wave with approximately the same intensity between the phased array antenna 10 and the reference antenna 20. Thereby, it is possible to simultaneously evaluate the H-polarized wave and the V-polarized wave, which are orthogonal to each other, by a single reference antenna 20.

Hereinafter, a specific example of the evaluation system 1 and evaluation method for simultaneously evaluating the H-polarized wave and the V-polarized wave using a single reference antenna 20 will be described with reference to FIGS. 2A to 2C.

The evaluation system 1A shown in FIG. 2A includes, in addition to the phased array antenna 10 and the reference antenna 20, a signal generator (SG) 41, two vector signal generators (VSGs) 42 and 43, and a measuring instrument 51. Hereinafter, the two vector signal generators 42 and 43 will be referred to as a first vector signal generator 42 and a second vector signal generator 43, respectively.

The signal generator 41 and each of the vector signal generators 42 and 43 are electrically connected to the phased array antenna 10. The signal generator 41 outputs an LO signal to the phased array antenna 10. The first vector signal generator 42 outputs an IF signal corresponding to the H-polarized wave to the phased array antenna 10. The second vector signal generator 43 outputs an IF signal corresponding to the V-polarized wave to the phased array antenna 10. Here, a frequency of the IF signal output by the first vector signal generator 42 and a frequency of the IF signal output by the second vector signal generator 43 are different from each other.

The phased array antenna 10 frequency-converts (up-converts) the IF signal received from the first vector signal generator 42 using the LO signal received from the signal generator 41. Thereby, the phased array antenna 10 generates the H-polarized wave. Also, the phased array antenna 10 frequency-converts (up-converts) the IF signal received from the second vector signal generator 43 using the LO signal received from the signal generator 41. Thereby, the phased array antenna 10 generates the V-polarized wave. Then, the phased array antenna 10 transmits the generated H-polarized wave and V-polarized wave simultaneously to the reference antenna 20.

The reference antenna 20 simultaneously receives the H-polarized wave and the V-polarized wave transmitted from the phased array antenna 10. Since the relative angle $\alpha$ between the phased array antenna 10 and the reference antenna 20 is approximately 45°, the reference antenna 20 receives the H-polarized wave and the V-polarized wave with approximately the same intensity. The reference antenna 20 outputs the received H-polarized wave and V-polarized wave to the measuring instrument 51 electrically connected to the reference antenna 20. The measuring instrument 51 is, for example, a spectrum analyzer (SA) or the like that measures an intensity of the radio waves received by the reference antenna 20 for each frequency.

Here, since the IF signals output by the signal generators 42 and 43 have different frequencies, a frequency (first frequency) of the H-polarized wave and a frequency (second frequency) of the V-polarized wave transmitted by the phased array antenna 10 are different from each other. Therefore, in the measuring instrument 51, it is possible to distinguish the H-polarized wave and the V-polarized wave based on the difference in frequency. In this manner, according to the evaluation system 1A shown in FIG. 2A, it is possible to perform evaluation of the H-polarized wave and the V-polarized wave simultaneously when the phased array antenna 10 transmits the radio waves.

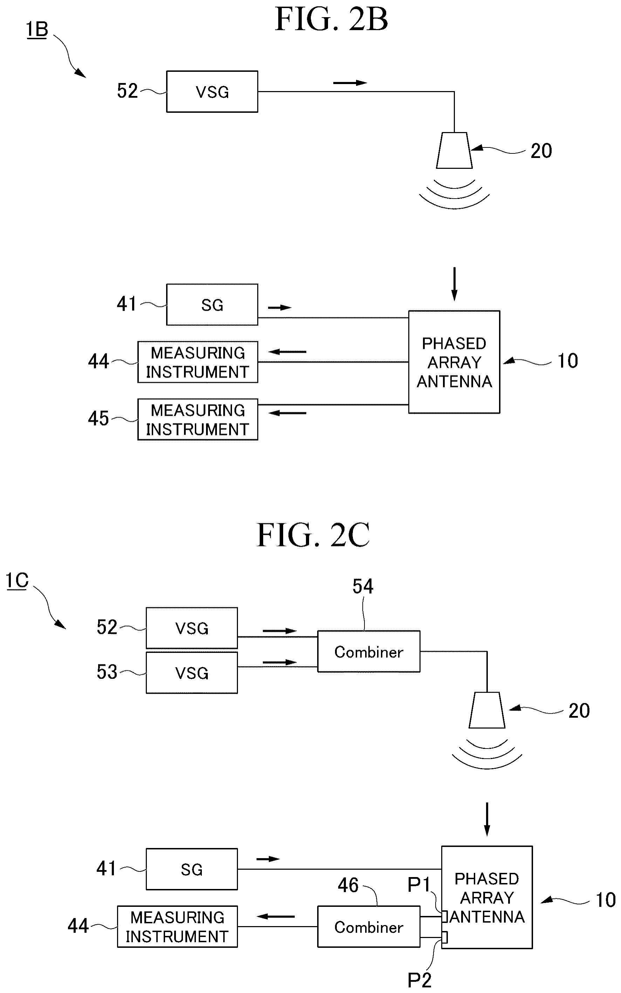

An evaluation system 1B shown in FIG. 2B has a configuration obtained by partially modifying the evaluation system 1A shown in FIG. 2A. That is, the evaluation system 1B has a configuration in which the vector signal generators 42 and 43 of the evaluation system 1A are replaced by two measuring instruments 44 and 45, and the measuring instrument 51 is replaced by a vector signal generator 52. Hereinafter, the two measuring instruments 44 and 45 will be referred to as a first measuring instrument 44 and a second measuring instrument 45, respectively.

The vector signal generator 52 is electrically connected to the reference antenna 20. The vector signal generator 52 outputs an RF signal having a single frequency (first frequency) to the reference antenna 20. The reference antenna 20 transmits radio waves oscillating in the reference direction E to the phased array antenna 10 on the basis of the RF signal received from the vector signal generator 52.

The phased array antenna 10 receives the radio waves transmitted from the reference antenna 20 based on each of a sensitivity in a direction parallel to the H-polarized wave and a sensitivity in a direction parallel to the V-polarized wave. In other words, of the radio waves oscillating in the reference direction E, a component in the H-polarization direction is received as the H-polarized wave, and a component in the V-polarization direction is received as the V-polarized wave. Since the relative angle $\alpha$ between the phased array antenna 10 and the reference antenna 20 is approximately 45°, the phased array antenna 10 receives the H-polarized wave and the V-polarized wave with approximately the same intensity.

The phased array antenna 10 frequency-converts (down-converts) the RF signal into an IF signal using an LO signal received from the signal generator 41. Since the phased array antenna 10 is capable of performing the frequency conversion independently for each of the H-polarized wave and the V-polarized wave, it outputs the IF signals of the H-polarized wave and the V-polarized wave to the first measuring instrument 44 and the second measuring instrument 45, respectively. That is, the IF signal of the H-polarized wave is output to the first measuring instrument 44, and the IF signal of the V-polarized wave is output to the second measuring instrument 45. The measuring instruments 44 and 45 are, for example, the spectrum analyzer described above, a power sensor (PS) that measures an intensity of the IF signal, or the like. According to this configuration, it is possible to independently perform evaluation of the H-polarized wave and the V-polarized wave by the first measuring instrument 44 and the second measuring instrument 45. In this manner, according to the evaluation system 1B shown in FIG. 2B, it is possible to perform evaluation of the H-polarized wave and the V-polarized wave simultaneously when the phased array antenna 10 receives the radio waves.

An evaluation system 1C shown in FIG. 2C has a configuration obtained by partially modifying the evaluation system 1B shown in FIG. 2B. That is, the evaluation system 1C has a configuration in which the second measuring instrument 45 is removed from the evaluation system 1B, and a vector signal generator 53 and two combiners 54 and 46 are added. Hereinafter, the two vector signal generators 52 and 53 will be referred to as a first vector signal generator 52 and a second vector signal generator 53, respectively. Also, the two combiners 54 and 46 are referred to as a first combiner 54 and a second combiner 46, respectively.

The first vector signal generator 52 outputs an RF signal having a single frequency (first frequency) to the first combiner 54. The second vector signal generator 53 outputs an RF signal having a single frequency (second frequency) different from the first frequency to the first combiner 54. The first combiner 54 synthesizes the RF signal received from the first vector signal generator 52 and the RF signal received from the second vector signal generator 53, and outputs the synthesized wave to the reference antenna 20. The reference antenna 20 simultaneously transmits a first radio wave having the first frequency and a second radio wave having the second frequency to the phased array antenna 10 on the basis of the synthesized RF signal.

The phased array antenna 10 receives each of the first radio wave and the second radio wave received from the reference antenna 20 based on each of a sensitivity in a direction parallel to the H-polarized wave and a sensitivity in a direction parallel to the V-polarized wave. Then, the phased array antenna 10 frequency-converts (down-converts) the RF signal into an IF signal using an LO signal received from the signal generator 41. The phased array antenna 10 is capable of performing the frequency conversion independently for each of the H-polarized wave and the V-polarized wave. Therefore, the phased array antenna 10 outputs an IF signal of the H-polarized wave having a frequency corresponding to the first frequency from a first port P1 to the second combiner 46. Then, the phased array antenna 10 outputs an IF signal of the V-polarized wave having a frequency corresponding to the second frequency from a second port P2 to the second combiner 46.

The second combiner 46 synthesizes the H-polarized wave having a frequency corresponding to the first frequency received from the first port P1 and the V-polarized wave having a frequency corresponding to the second frequency received from the second port P2. The second combiner 46 outputs the synthesized wave to the measuring instrument 44. Even with the evaluation system 1C, as in the above-described evaluation system 1B, it is possible to perform evaluation of the H-polarized wave and the V-polarized wave simultaneously when the phased array antenna 10 receives the radio waves. The evaluation system 1C has an advantage in that it is possible to reduce the number of measuring instruments compared to the evaluation system 1B, and it is possible to easily realize a reduction in size of the entire evaluation system.

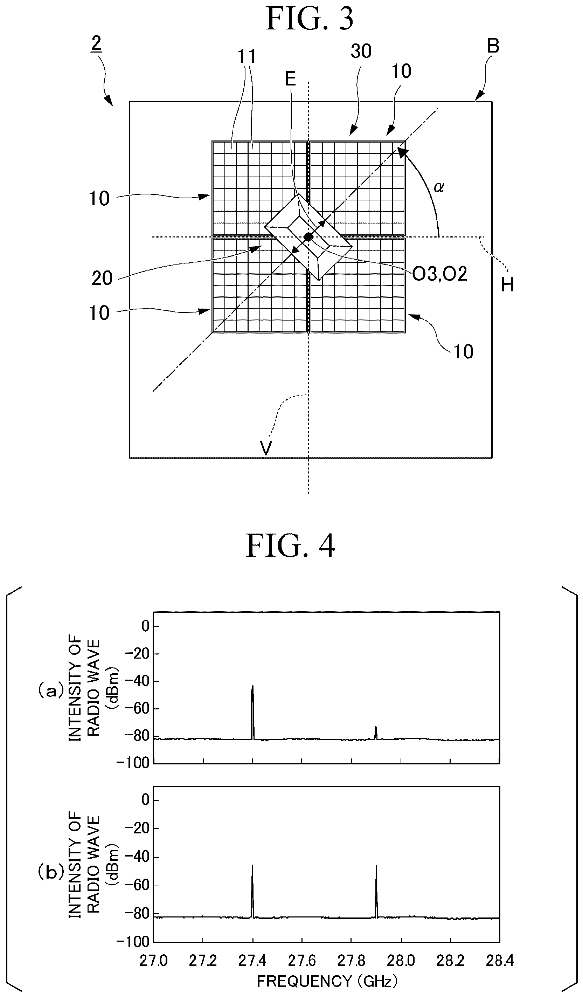

The evaluation system 1 described above is a system that evaluates the phased array antenna 10 using the reference antenna 20. However, as in an evaluation system 2 shown in FIG. 3, an evaluation for a phased array antenna group 30 may be performed using the reference antenna 20. The phased array antenna group 30 includes a plurality (four in the illustrated example) of phased array antennas 10. The plurality of phased array antennas 10 are arranged (tiled) in the V-polarization direction and the H-polarization direction. In this case, it is desirable to dispose the phased array antenna group 30 and the reference antenna 20 so that a center O3 of the phased array antenna group 30 and the center O2 of the reference antenna 20 overlap in a plan view. Note that, it is possible to consider the phased array antenna group 30 in the illustrated example as a phased array antenna having a total of two-hundred and fifty-six antennas 11, with sixteen antennas 11 arranged in both the V-polarization direction and the H-polarization direction.

Examples

Hereinafter, the above-described embodiment will be described using specific examples. Note that, the present invention is not limited to the following examples.

(Example 1)

Using the evaluation system 1A shown in FIG. 2A, the H-polarized wave and the V-polarized wave were transmitted simultaneously from the phased array antenna 10, and evaluations of both the polarized waves were performed simultaneously. Specific conditions are as follows:

> A frequency (f1) of an LO signal output by the signal generator 41: 6.1 (GHz)
> A frequency (f2) of an IF signal output by the first vector signal generator 42: 3.0 (GHz)
> A frequency (f3) of an IF signal output by the second vector signal generator 43: 3.5 (GHz)
> A frequency (fh) of the H-polarized wave: 27.4 (GHz)
> A frequency (fv) of the V-polarized wave: 27.9 (GHz)
> The measuring instrument 51: Spectrum analyzer

Note that, in the present example, the frequency fh of the H-polarized wave is not simply a sum of the frequency f1 of the LO signal and the frequency f2 of the IF signal. This is because the phased array antenna 10 in the present example generates a fourth harmonic of the LO signal and mixes the fourth harmonic with the IF signal to frequency-convert the IF signal into an RF signal.

That is, the following two expressions hold.

$$fh = f2 + 4 \times f1$$

$$fv = f3 + 4 \times f1$$

FIG. 4(a) shows measurement results obtained by the measuring instrument 51 (spectrum analyzer) when the relative angle between the phased array antenna 10 and the reference antenna 20 is set as $\alpha = 0°$. FIG. 4(b) shows measurement results obtained by the measuring instrument 51 when the relative angle between the phased array antenna 10 and the reference antenna 20 is set as $\alpha = 45°$. Note that, units of the horizontal axes are the same in FIGS. 4(a) and (b).

As shown in FIG. 4(a), when $\alpha = 0°$, a detected intensity of the V-polarized wave is significantly lower than a detected intensity of the H-polarized wave. This is because, when $\alpha = 0°$, the reference direction E is parallel to the H-polarization direction, whereas the reference direction E is perpendicular to the V-polarization direction. On the other hand, as shown in FIG. 4B, when α is set to 45°, a detected intensity of the V-polarized wave is dramatically improved compared to when α is 0°. Specifically, in the present example, the detected intensity of the V-polarized wave was improved by 26.8 dB. Thereby, the detected intensity of the H-polarized wave and the detected intensity of the V-polarized wave are approximately the same. Note that, the detected intensity of the H-polarized wave was reduced by 2.7 dB compared to a case in which α = 0°. However, since the amount of reduction is small enough that it is capable of being adequately addressed by prior measurement, it does not have a significant adverse effect on the measurement. In this manner, it has been ascertained that simultaneous evaluation of the H-polarized wave and the V-polarized wave is possible by setting the relative angle between the phased array antenna 10 and the reference antenna 20 as α = 45°.

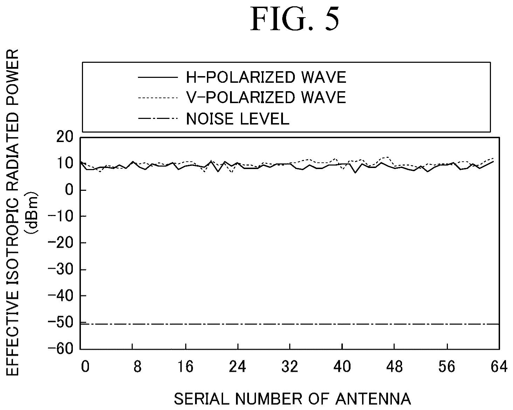

FIG. 5 is a graph showing results of measuring effective isotropic radiated power (EIRP) of the H-polarized wave and effective isotropic radiated power of the V-polarized wave for each of the 64 antennas 11 included in the phased array antenna 10. Note that, the horizontal axis represents serial numbers (0 to 63) assigned to the antennas 11. For example, when the number 0 antenna 11 was measured, the measurement is performed with only the number 0 antenna 11 turned ON and all the antennas 11 other than the number 0 set to OFF.

As shown in FIG. 5, the detected intensity of the H-polarized wave and the detected intensity of the V-polarized wave were approximately the same for all the antennas 11. In this way, according to the method of the present embodiment, it is possible to simultaneously evaluate whether each antenna 11 is capable of normally transmitting and receiving both the H-polarized wave and the V-polarized wave.

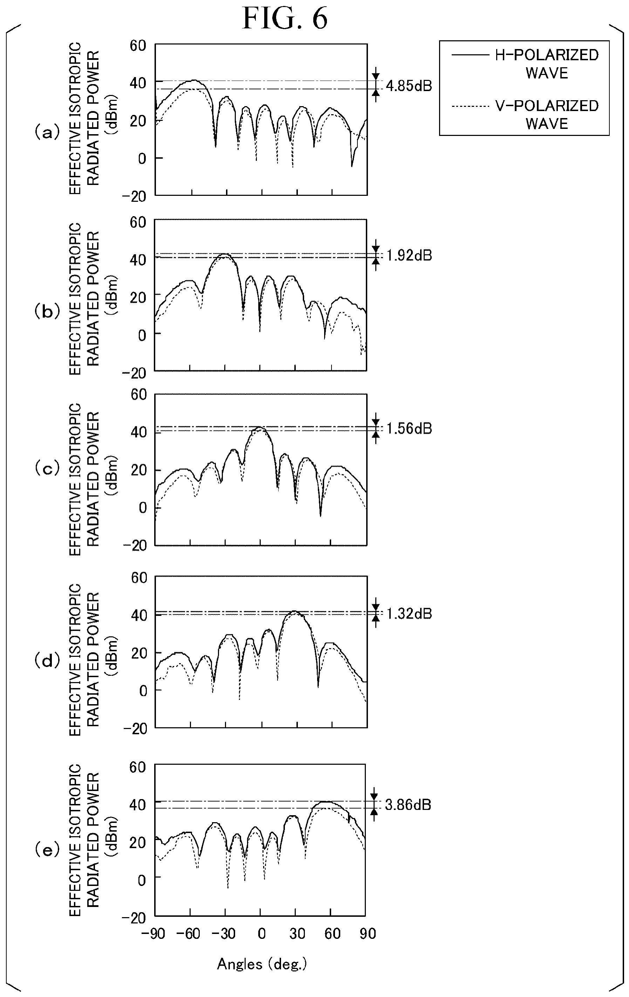

FIGS. 6(a) to (e) are graphs showing beam patterns of the phased array antenna 10 according to the present example. Note that, units of the horizontal axes are the same in FIGS. 6(a) to (e). FIG. 6(a) shows a case in which a beam directivity angle θ is -60°. FIG. 6(b) shows a case in which the beam directivity angle θ is -30°. FIG. 6(c) shows a case in which the beam directivity angle θ is 0°. FIG. 6(d) shows a case in which the beam directivity angle θ is 30°. FIG. 6(e) shows a case in which the beam directivity angle θ is 60°. Note that, "4.85 dB" or the like shown on a right side of each diagram indicates a difference between a maximum value of the effective isotropic radiated power of the H-polarized wave and a maximum value of the effective isotropic radiated power of the V-polarized wave.

As shown in FIG. 6, no significant difference was ascertained between the beam patterns of the H-polarized wave and the beam patterns of the V-polarized wave at any of the beam directivity angles θ. In this way, according to the method of the present embodiment, it is possible to simultaneously evaluate the beam pattern of the H-polarized wave and the beam pattern of the V-polarized wave in the phased array antenna 10.

(Example 2)

The phased array antenna 10 of the evaluation system 1A shown in FIG. 2A was replaced with the phased array antenna group 30 (see FIG. 3). Then, a beam pattern of the phased array antenna group 30 was measured under the condition of α = 45°. Note that, the conditions for each frequency are the same as those in example 1.

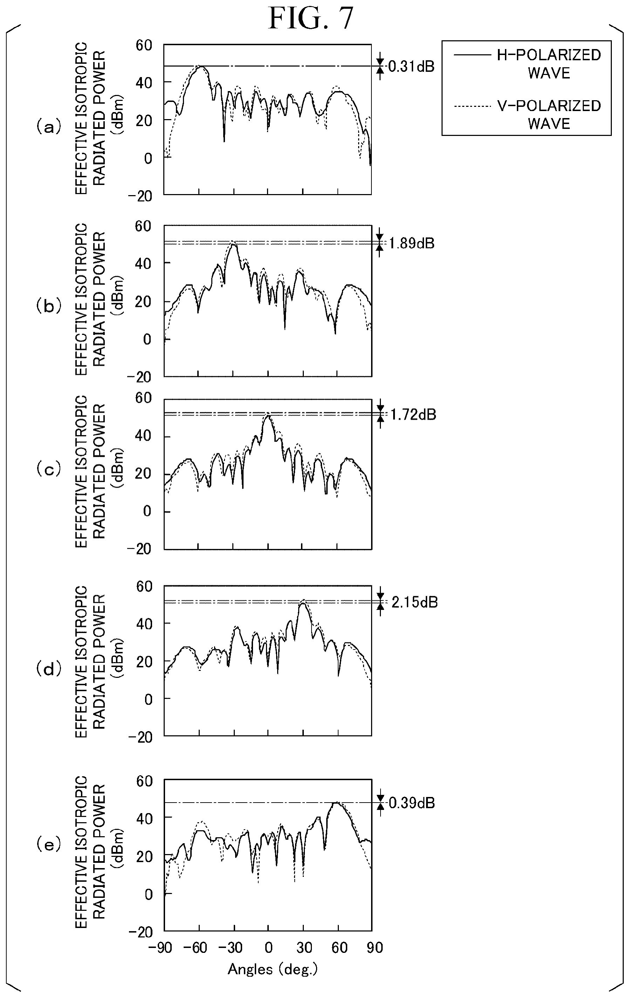

FIGS. 7(a) to (e) are graphs showing beam patterns of the phased array antenna group 30 according to the present example. Note that, units of the horizontal axes are the same in FIGS. 7(a) to (e). FIG. 7(a) shows a case in which the beam directivity angle θ is -60°. FIG. 7(b) shows a case in which the beam directivity angle θ is -30°. FIG. 7(c) shows a case in which the beam directivity angle θ is 0°. FIG. 7(d) shows a case in which the beam directivity angle θ is 30°. FIG. 7(e) shows a case in which the beam directivity angle θ is 60°. Note that, "0.31 dB" or the like shown on a right side of each diagram indicates a difference between a maximum value of the effective radiated power of the H-polarized wave and a maximum value of the effective radiated power of the V-polarized wave.

As shown in FIG. 7, no significant difference was ascertained between the beam patterns of the H-polarized wave and the beam patterns of the V-polarized wave at any of the beam directivity angles θ. In this way, according to the method of the present embodiment, it is possible to simultaneously evaluate the beam pattern of the H-polarized wave and the beam pattern of the V-polarized wave in the phased array antenna group 30.

(Example 3)

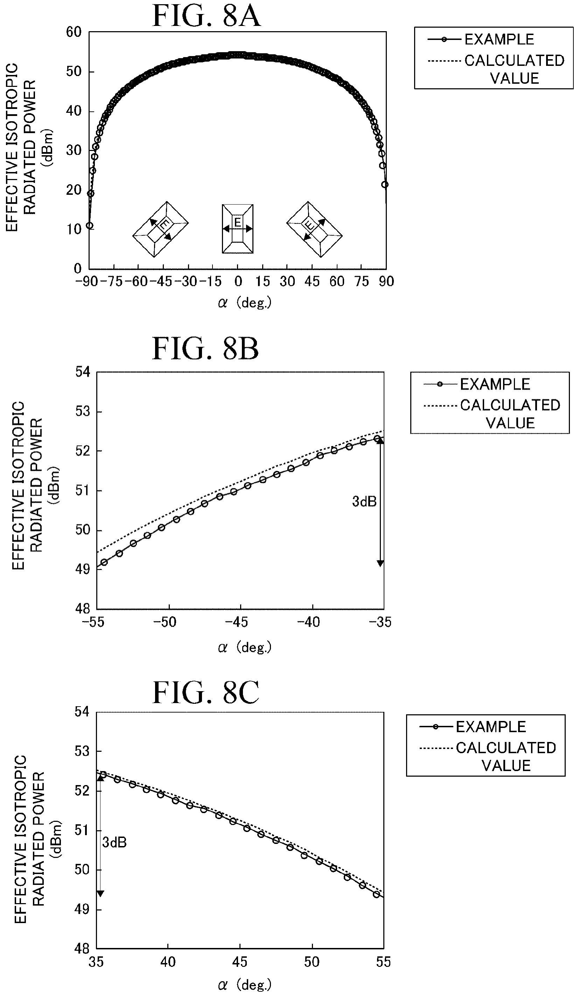

In the evaluation system 1A shown in FIG. 2A, a value of α was changed within a range of -90° ≤ α ≤ 90°, and an intensity of the H-polarized wave was measured for each value of α. FIG. 8A is a graph showing measured values (in the example) and calculated values. FIG. 8B is a graph in which a range of -55° ≤ α ≤ -35° is extracted from the graph of FIG. 8A. FIG. 8C is a graph in which a range of 35° ≤ α ≤ 55° is extracted from the graph of FIG. 8A.

As shown in FIG. 8A, it was ascertained that the intensity of the H-polarized wave decreased rapidly in a range in which, for example, an absolute value of α exceeded 75°. On the other hand, as shown in FIGS. 8B and 8C, in a range in which the absolute value of α is in a range of 35° or more and 55° or less (35° ≤ |α| ≤ 55°), the effective radiated power of the H-polarized wave falls within a range of 3 dB with a case in which α = 45° as a center, and no significant change was ascertained. Therefore, in the simultaneous evaluation of the H-polarized wave and the V-polarized wave, the value of α does not necessarily have to be exactly 45°, and it is considered sufficient that the value of $\alpha$ is within the range of 35° or more and 55° or less. That is, it is considered that, when $\alpha$ is set within the range of 35° or more and 55° or less, it is possible to perform simultaneous evaluation of the H-polarized wave and the V-polarized wave with high accuracy.

However, even when $\alpha$ is less than 35° or greater than 55°, as long as $|\alpha| \neq 0°$ and $|\alpha| \neq 90°$, it is possible to perform simultaneous evaluation of the H-polarized wave and the V-polarized wave.

In view of the above, the present embodiment proposes an evaluation method for a phased array antenna, which evaluates the phased array antenna 10 including a plurality of antennas 11 that perform transmission or reception of a first polarized wave (H-polarized wave) and a second polarized wave (V-polarized wave) whose oscillation directions are orthogonal to each other, including using the reference antenna 20 disposed to face the phased array antenna 10 and performing transmission or reception of radio waves that oscillate in the reference direction E, and performing evaluation of the first polarized wave and the second polarized wave simultaneously in a state in which the first direction (H-polarization direction) in which the first polarized wave oscillates is not parallel to the reference direction E when viewed from a facing direction in which the phased array antenna 10 and the reference antenna 20 face each other, and the second direction (V-polarization direction) in which the second polarized wave oscillates is not parallel to the reference direction E when viewed from the facing direction.

According to this configuration, since the reference direction E is not parallel to either the H-polarization direction or the V-polarization direction, it is possible to perform simultaneous evaluation of the H-polarized wave and the V-polarized wave. In other words, compared to a case in which the reference direction E is parallel to the H-polarization direction or the V-polarization direction (when $\alpha = 0°$ or $\alpha = 90°$), it is possible to ensure both the intensity of the H-polarized wave and the intensity of the V-polarized wave. Thereby, it is possible to simultaneously evaluate the H-polarized wave and the V-polarized wave with the reference antenna 20. Also, it is possible to implement this method with a single reference antenna 20.

Also, when viewed from the facing direction, the relative angle $\alpha$ between the first direction and the reference direction E may be 35° or more and 55° or less. According to this configuration, an angle formed by the H-polarization direction and the reference direction E and the angle formed by the V-polarization direction and the reference direction E can be made approximately the same. Thereby, the H-polarized wave and the V-polarized waves can be transmitted and received with approximately the same intensity between the phased array antenna 10 and the reference antenna 20. That is, with a sufficiently high S/N ratio from a noise level of the measuring instrument, it is possible to measure the H-polarized wave and the V-polarized wave at approximately the same intensity level. Thereby, the H-polarized wave and the V-polarized wave can be evaluated simultaneously with high accuracy.

Also, the center O1 of the phased array antenna 10 and the center O2 of the reference antenna 20 may coincide when viewed from the facing direction. According to the above-described method in which it is possible to perform evaluation of the H-polarized wave and the V-polarized wave using a single reference antenna 20, it becomes possible to perform the evaluation with both the centers O1 and O2 coinciding as described above.

Also, the first polarized wave having a first frequency and the second polarized wave having a second frequency different from the first frequency may be simultaneously transmitted from the phased array antenna 10, and the first polarized wave and the second polarized wave may be simultaneously received by the reference antenna 20. According to this configuration, it is possible to simultaneously perform evaluation of the H-polarized wave and the V-polarized wave when the phased array antenna 10 transmits radio waves.

Also, a first radio wave having a first frequency may be transmitted from the reference antenna 20, and the first radio wave may be received by the phased array antenna 10. According to this configuration, it is possible to simultaneously perform evaluation of the H-polarized wave and the V-polarized wave when the phased array antenna 10 receives radio waves.

Also, the first radio wave and the second radio wave which has a second frequency different from the first frequency may be transmitted from the reference antenna 20, and the first radio wave and the second radio wave may be received simultaneously by the phased array antenna. Even with this configuration, it is possible to perform the above-described simultaneous evaluation when the phased array antenna 10 receives radio waves.

Note that, the technical scope of the present invention is not limited to the above-described embodiment, and various modifications may be made within a range not departing from the spirit of the present invention.

For example, a type of the reference antenna 20 is not limited to a horn antenna, and may be appropriately changed as long as it is possible to transmit and receive radio waves between itself and the phased array antenna 10. Even in this case, when the relative angle $\alpha$ between the reference direction E of the reference antenna 20 and the H-polarization direction is set within the range of 35° or more and 55° or less, it is possible to obtain the same operation and effect as those of the above-described embodiment.

Also, the phased array antenna 10 may perform only one of transmitting and receiving radio waves. Similarly, the reference antenna 20 may perform only one of transmitting and receiving radio waves.

Also, the evaluation systems 1 and 2 may include an angle adjustment mechanism for adjusting α. In this case, the angle adjustment mechanism may be a mechanism that rotates the phased array antenna 10 or the phased array antenna group 30, a mechanism that rotates the reference antenna 20, or a mechanism that rotates both.

In addition, the components in the above-described embodiment may be appropriately replaced with well-known components within a range not departing from the spirit of the present invention, and the embodiment and modified examples described above may be appropriately combined.

Reference Signs List

    10 Phased array antenna
    11 Antenna
    20 Reference antenna
    E Reference direction
    α Relative angle

**Claims**

1.  An evaluation method for a phased array antenna, which evaluates a phased array antenna including a plurality of antennas that perform transmission or reception of a first polarized wave and a second polarized wave whose oscillation directions are orthogonal to each other, comprising:

    using a reference antenna disposed to face the phased array antenna and performing transmission or reception of radio waves that oscillate in a reference direction; and
    performing evaluation of the first polarized wave and the second polarized wave simultaneously in a state in which a first direction in which the first polarized wave oscillates is not parallel to the reference direction when viewed from a facing direction in which the phased array antenna and the reference antenna face each other, and a second direction in which the second polarized wave oscillates is not parallel to the reference direction when viewed from the facing direction.

2.  The evaluation method for a phased array antenna according to claim 1, wherein a relative angle between the first direction and the reference direction is 35° or more and 55° or less when viewed from the facing direction.

3.  The evaluation method for a phased array antenna according to claim 1, wherein a center of the phased array antenna and a center of the reference antenna coincide when viewed from the facing direction.

4.  The evaluation method for a phased array antenna according to any one of claims 1 to 3, wherein

    the first polarized wave having a first frequency and the second polarized wave having a second frequency different from the first frequency are simultaneously transmitted from the phased array antenna, and
    the first polarized wave and the second polarized wave are simultaneously received by the reference antenna.

5.  The evaluation method for a phased array antenna according to any one of claims 1 to 3, wherein

    a first radio wave having a first frequency is transmitted from the reference antenna, and
    the first radio wave is received by the phased array antenna.

6.  The evaluation method for a phased array antenna according to claim 5, wherein

    the first radio wave and the second radio wave which has a second frequency different from the first frequency are transmitted from the reference antenna, and
    the first radio wave and the second radio wave are simultaneously received by the phased array antenna.

# FIG. 1

# FIG. 2A

# FIG. 2B

1B

# FIG. 2C

1C

## FIG. 3

## FIG. 4

# FIG. 5

# FIG. 6

# FIG. 7

## FIG. 8A

## FIG. 8B

## FIG. 8C

## INTERNATIONAL SEARCH REPORT

| International application No. |
|---|
| **PCT/JP2024/002505** |

| A. | CLASSIFICATION OF SUBJECT MATTER |
|---|---|

*H01Q 21/06*(2006.01)i; *G01R 29/10*(2006.01)i
FI: H01Q21/06; G01R29/10 C; G01R29/10 E

According to International Patent Classification (IPC) or to both national classification and IPC

| B. | FIELDS SEARCHED |
|---|---|

Minimum documentation searched (classification system followed by classification symbols)

H01Q21/06; G01R29/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2019-132836 A (ROCKWELL COLLINS INC.) 08 August 2019 (2019-08-08) | 1-6 |
| A | JP 2002-243782 A (ANRITSU CORP.) 28 August 2002 (2002-08-28) | 1-6 |
| A | US 11474138 B1 (ROHDE & SCHWARZ GMBH & CO. KG) 18 October 2022 (2022-10-18) | 1-6 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 March 2024** | **09 April 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/002505**

| Patent document cited in search report | | | Publication date (day/month/year) | Patent family member(s) | | | Publication date (day/month/year) |
|---|---|---|---|---|---|---|---|
| JP | 2019-132836 | A | 08 August 2019 | US | 2019/0235003 | A1 | |
| | | | | EP | 3521842 | A1 | |
| | | | | CN | 110095658 | A | |
| | | | | KR | 10-2019-0093124 | A | |
| JP | 2002-243782 | A | 28 August 2002 | (Family: none) | | | |
| US | 11474138 | B1 | 18 October 2022 | CN | 115993487 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023020631 A
- JP 2010124360 A